# EUROPÄISCHE PATENTSCHRIFT

(11) **EP 4 049 323 B1**
(45) Veröffentlichungstag und Bekanntmachung des Hinweises auf die Patenterteilung: **04.09.2024**
(21) Anmeldenummer: 20792376.4
(22) Anmeldetag: 13.10.2020
(51) Int. Cl.: H10N 30/05, H10N 30/063, H10N 30/50, H10N 30/857, H10N 30/87

(54) **DIELEKTRISCHER WANDLER, VERFAHREN ZU DESSEN HERSTELLUNG SOWIE AKTOR, SENSOR ODER GENERATOR**
DIELECTRIC TRANSDUCER, METHOD FOR THE PRODUCTION THEREOF AND ACTUATOR, SENSOR OR GENERATOR
TRANSDUCTEUR DIÉLECTRIQUE, SON PROCÉDÉ DE FABRICATION ET ACTIONNEUR, CAPTEUR OU GÉNÉRATEUR

(30) Priorität: 25.10.2019 DE 102019128822
(43) Veröffentlichungstag der Anmeldung: 31.08.2022
(73) Patentinhaber: Delfa Systems GmbH, 66538 Neunkirchen (DE)
(72) Erfinder: HAU, Steffen, 66424 Homburg (DE); LENZ, Stephan, 66119 Saarbrücken (DE); LINNEBACH, Philipp, 66557 Illingen (DE); MEIER, Dennis, 66606 St. Wendel (DE); SEELECKE, Stefan, Saarbrücken 66119 (DE)
(74) Vertreter: Zeiner, Johannes Michael
(86) Internationale Anmeldenummer: PCT/EP2020/078782
(87) Internationale Veröffentlichungsnummer: WO 2021/078589

(56) Entgegenhaltungen:
- EP-A1- 3 672 057
- EP-A2- 2 323 188
- WO-A1-2019/065010
- US-A1- 2016 126 450
- US-A1- 2019 103 549

## Beschreibung

Die Erfindung betrifft einen dielektrischen Wandler zur Verwendung in einem Sensor oder Aktor, der mehrere Lagen Wandlerfolien umfasst, wobei auf wenigstens eine Seite einer jeden Wandlerfolie eine elektrisch kontaktierbare und leitfähige Elektrodenlage aufgebracht ist, und mindestens zwei Kontaktelemente vorgesehen sind, von denen jedes wenigstens teilweise in einer Ausnehmung oder in einem Durchgangskanal angeordnet ist und sich über mindestens eine Lage Wandlerfolien erstreckt, wobei benachbarte Elektrodenlagen mit verschiedenen Kontaktelementen elektrisch leitend verbunden sind. Ferner betrifft die Erfindung einen Aktor, Sensor oder Generator.

WO 2019/065010 A1 beschreibt einen piezoelektrischen Wandler 10 mit mehreren Lagen Wandlerfolien 13, die Elektrodenlagen 11a, 11b umfassen, die abwechselnd mit einer ersten 15a oder einer zweiten Kontaktelektrode 15b verbunden sind.

US 2016/0126450 A1 offenbart in Fig. 1a einen dielektrischen Stapelwandler 10 mit mehreren Lagen 17 Wandlerfolien 16, die Elektrodenlagen 20, 22 aufweisen, die abwechselnd mit einer ersten 26 oder einer zweiten Kontaktelektrode 27 verbunden sind. Durch eine Auslenkung senkrecht zu einer Folienebene der Wandlerfolien ist der Wandler zur Steuerung eines Ventils nutzbar.

Aus dem Stand der Technik sind außerdem mehrlagige dielektrische Wandler zur Verwendung in Aktoren, Sensoren oder Generatoren bekannt.

Mehrere Folien, die beispielsweise aus Silikon oder einem eine Acrylgruppe aufweisenden Kunststoff gebildet sind, werden auf wenigstens einer Seite mit einem elektrisch leitfähigen Material zur Bildung von Elektroden beschichtet und danach laminiert. Eine elektrische Kontaktierung erfolgt, indem einzelne Elektrodenlagen einzeln kontaktiert werden, dazu erforderliche Kontaktleitungen zusammengeführt und an einen Pol einer Spannungsquelle, einer Auswerteinrichtung oder einer Messschaltung angeschlossen werden. Nachteilig ist, dass eine aus dem Stand der Technik bekannte Kontaktierung der Elektrodenlagen sehr aufwendig und nicht ausreichend stabil für eine dauerhafte, zuverlässige Benutzung ist.

Aus EP 2 323 188 B1 ist ein mehrlagiger Aktor bekannt, dessen Kunststofflagen jeweils eine Nichtbetätigungsschicht sowie eine Betätigungsschicht aufweisen, wobei die Nichtbetätigungsschicht ausschließlich zur elektrischen Kontaktierung ("Erweiterungselektroden") eingerichtet ist und mit der Betätigungsschicht mechanisch und elektrisch verbunden ist. Die Betätigungsschicht ist diejenige Schicht, die sogenannte Antriebselektroden umfasst, die aktorisch wirken.

Obwohl die Nichtbetätigungsschicht und die Betätigungsschicht gleich dick sein können, ist die Nichtbetätigungsschicht vorzugsweise dicker als die Betätigungsschicht und aus einem anderen Material gebildet. Kontaktelektroden zur elektrischen Verbindung benachbarter Schichten mit unterschiedlichen Polen einer Spannungsquelle sind in die Nichtbetätigungsschicht eingebracht. Die Schichten sind aus einem Metall oder einer Metalllegierung gebildet, wodurch in einer Folienebene lediglich Dehnungen der einzelnen Kunststofflagen von < 10% möglich sind.

Außerdem ist der aus EP 2 323 188 B1 bekannte Wandler ein sogenannter Stapelaktor, bei dem ausschließlich eine Bewegung in Dickenrichtung der Kunststofflagen möglich ist.

Der vorliegenden Erfindung liegt die Aufgabe zugrunde, einen mehrlagigen dielektrischen Wandler der eingangs genannten Art auszubilden, der besonders weit auslenkbar ist.

Erfindungsgemäß wird die Aufgabe dadurch gelöst, dass der dielektrische Wandler als Membranwandler ausgebildet ist, dessen Wandlerfolien in einer Folienebene auslenkbar sind.

Obwohl denkbar ist, dass ein Wandler als Stapelwandler ausgebildet ist, dessen Wandlerfolien bei Benutzung senkrecht zu einer Folienebene auslenkbar sind, ist der erfindungsgemäße dielektrische Wandler ein Membranwandler, das heißt ein Wandler, dessen Wandlerfolien bei Benutzung in einer Folienebene auslenkbar sind. Bei Auslenkung sind Dehnungen in Längsrichtung von bis zu 100 % möglich.

Für jeden Pol kann ein einziges Kontaktelement vorgesehen sein, das mit den zu kontaktierenden Elektrodenlagen elektrisch leitend verbunden ist, beispielsweise stoff-, form- und/oder kraftschlüssig. Sind zwei Kontaktelemente vorgesehen, kann eines mit einem Pluspol und das zweite mit einem Minuspol einer Spannungsquelle, einer Auswerteinrichtung oder einer Messschaltung verbunden werden. Dadurch, dass die benachbarte Elektrodenlagen mit unterschiedlichen Kontaktelementen verbunden sind, ist eine bestimmungsgemäße Benutzung möglich, ein Zusammenführen mehrere Kontaktleitungen ist vorteilhaft nicht erforderlich.

Ein besonders ausfallsicherer Wandler umfasst mehrere Kontaktelemente, von denen einige mit dem Pluspol und andere dem dem Minuspol einer Spanungsquelle, einer Auswerteinrichtung oder einer Messschaltung verbindbar oder verbunden sind.

Ein Durchgangskanal erstreckt sich von einer Seite des Wandlers zu einer gegenüberliegenden Seite, insbesondere mit einer Richtungskomponente senkrecht zu einer Längsrichtung des Wandlers, beispielsweise in Dickenrichtung, und eine Ausnehmung ist vorzugsweise als Sackloch ausgebildet.

Ferner wird ein Verfahren (nicht Teil der Erfindung) beschrieben, das eine einfache sowie besonders prozessstabile Herstellung eines mehrlagigen, dielektrischen Wandlers ermöglicht.

### Dieses (nicht erfindungsgemäße)

Verfahren ist dadurch gekennzeichnet, dass mindestens eine der Wandlerfolien mit einer Durchgangsöffnung versehen wird und mehrere Wandlerfolien zur Bildung des Wandlers laminiert werden, oder mehrere Wandlerfolien zur Bildung des Wandlers laminiert werden und danach mit mindestens zwei Ausnehmungen und/oder Durchgangskanälen versehen werden, die zur Aufnahme von Kontaktelementen vorgesehen sind.

Entweder werden die mit einer leitfähigen Schicht versehenen Wandlerfolien vor deren Laminierung mit einer Durchgangsöffnung versehen und danach laminiert oder eine Einbringung von Ausnehmungen oder Durchgangskanälen erfolgt in einen bereits laminierten Wandlerfolienstapel.

Im ersten Fall kann ein Wandler von mehreren, speziell bearbeiteten Wandlerfolien gebildet werden, wobei Durchgangsöffnungen mehrerer laminierter Wandlerfolien Durchgangskanäle oder Ausnehmungen bilden. Denkbar ist, dass nicht jede Wandlerfolie mit einer Durchgangsöffnung versehen ist. Beispielsweise können obere und/oder untere Decklagen vorgesehen sein.

Im zweiten Fall ist ein Wandler auf einfache Weise aus einem standardisierten Halbzeug herstellbar.

Eine Laminierung kann beispielsweise erfolgen, indem benachbarte Wandlerfolien in Randbereichen miteinander verklebt werden.

Ist eine Wandlerfolie aus einem Material gebildet, das Polysiloxan ("Silikon") aufweist, ist eine Oberflächenaktivierung mittels Plasma denkbar, so dass bei Kontakt zweier aktivierter Oberflächen von zwei benachbarten Wandlerfolien eine stoffschlüssige Verbindung ausgebildet wird.

Zweckmäßigerweise erstreckt sich mindestens eines der Kontaktelemente in Dickenrichtung in den Wandler hinein, oder umfasst eine Beschichtung, die eine Innenseite der Ausnehmung oder des Durchgangskanals belegt. Vorteilhaft wird ein besonders kompakter mehrlagiger Wandler geschaffen, dessen Kontaktelemente zumindest teilweise in die Lagen eingebracht sind. Zum Anlegen einer Spannung zum Betrieb des Wandlers müssen lediglich zwei Kontaktelemente, die beispielsweise aus einem Wandlerfolienlagenstapel vorstehen können, kontaktiert werden. Ferner können die Kontaktelemente neben einer elektrischen Kontaktierungsmöglichkeit eine Stabilisierung eines Lagenstapels bewirken. Dazu können die Kontaktelemente ausgebildet werden, indem Ausnehmungen oder Durchtrittskanäle in dem Wandler mit einem insbesondere flüssigen oder viskosen, aushärtbaren und elektrisch leitfähigen Material ausgegossen werden. Die Ausnehmungen und/oder die Durchtrittskanäle sind symmetrisch, vorzugsweise rotationssymmetrisch.

Denkbar ist, dass mehrere Ausnehmungen oder Durchtrittskanäle voneinander verschieden sind. Beispielsweise kann eine Ausnehmung oder ein Durchtrittskanal kreiszylindrisch ausgebildet sein, während eine andere Ausnehmung oder ein anderer Durchtrittskanal zylindrisch mit einer rechteckigen, dreieckigen oder sternförmigen Grundfläche ausgebildet ist.

In einer Ausgestaltung der Erfindung ist mindestens eines der Kontaktelemente treppen- oder kammartig ausgebildet. Bei einer kammartigen Ausbildung weist das Kontaktelement mehrere sich in die Lagen hineinerstreckende Zähne auf, die unterschiedlich lang sind und von denen jeder Zahn mindestens eine Elektrodenlage, vorzugsweise mehrere, kontaktiert. Dadurch, dass eine Elektrodenlage von mehreren Zähnen kontaktiert wird, wird eine besonders gute elektrische Verbindung des Kontaktelementes mit den Elektrodenlagen ausgebildet. Kontaktverluste an einem Zahn können durch einen anderen Zahn ausgeglichen werden.

Ist das Kontaktelement treppenförmig ausgebildet, können die Stufen eine Verjüngung des Kontaktelementes in einer Lagenrichtung bewirken oder insbesondere linear zueinander versetzt angeordnet sein.

Denkbar ist ferner eine Ausbildung des Kontaktelements als im Wesentlichen schiefer, gestufter Zylinder.

In einer weiteren Ausgestaltung der Erfindung weist die Elektrodenlage ein nichtmetallisches Material auf oder ist aus einem nichtmetallischen Material gebildet, insbesondere Kohlenstoff, vorzugsweise in eine Kunststoffmatrix eingebettete Kohlenstoffpartikel. Vorteilhaft wird eine stabile und elektrisch leitfähige Beschichtung ausgebildet. Wird in eine Kunststoffmatrix eingebetteter Kohlenstoff verwendet, wird eine besonders dehnbare Elektrodenlage ausgebildet. Ein Aktor, Sensor oder Generator, der eine solche Elektrodenlage aufweist, kann in einer Folienebene in einer Längsrichtung ohne Beschädigung der Elektrodenlage mehr als 10%, sogar bis zu 100%, gedehnt werden. Vorteilhaft ist, wenn die Wandlerfolie aus Polysiloxan gebildet und mit einer Kohlenstoff aufweisenden Elektrodenlage beschichtet ist. Denkbar ist, dass die Elektrodenlage aus einem elektrisch leitfähigen Nichtmetall gebildet ist, beispielsweise aus einem elektrisch leitenden Kunststoff.

Zweckmäßigerweise umfasst jede Wandlerfolie mindestens einen Oberflächenbereich, in dem die Elektrodenlage unterbrochen ist. Es wird ein Sicherheitsbereich geschaffen, der elektrisch nicht leitend ist. Eine den Wandler zerstörende Fehlkontaktierung einer Elektrodenlage mit einem der Kontaktelemente kann vorteilhaft verhindert werden.

In einer Ausgestaltung der Erfindung ist ein Kontaktbereich, in dem eines der Kontaktelemente elektrisch und mechanisch mit einer der Elektrodenlagen verbunden ist, vorgesehen, wobei sich der Kontaktbereich vorzugsweise wenigstens teilweise in Umfangsrichtung des Kontaktelements erstreckt. Vorteilhaft sind die Wandlerfolien besonders einfach mit dem Kontaktelement verbindbar.

Denkbar ist, dass der Kontaktbereich wenigstens teilweise mit einer Schicht belegt ist, die beispielsweise zur Kontakt- und/oder Haftverbesserung der Elektrodenlage mit einem der Kontaktelemente vorgesehen ist. Erstreckt sich der Kontaktbereich wenigstens teilweise in Umfangsrichtung des Kontaktelements, wird ein besonders großer Kontaktbereich geschaffen, durch den vorteilhaft eine besonders gute Kontaktierung sichergestellt werden kann, die außerdem besonders prozesssicher herstellbar ist.

In einer Ausgestaltung der Erfindung weisen die Wandlerfolien eine Dicke zwischen 5 µm und 200 µm auf, insbesondere zwischen 10 µm und 100 µm, besonders bevorzugt zwischen 20 µm und 50 µm, und/oder sind aus einem Polymermaterial gebildet, das Polysiloxan umfasst. Polysiloxan ist ein sehr dehnbares Material, durch das Auslenkungen eines erfindungsgemäßen Wandlers möglich sind, die in Längsrichtung einer Wandlerfolie bis zu 100% betragen können.

In einer weiteren Ausgestaltung der Erfindung beträgt die Dicke einer Elektrodenlage zwischen 500 nm und 100 µm, vorzugsweise zwischen 1 µm und 50 µm, besonders bevorzugt zwischen 1 µm und 5 µm. Diese Dicken haben sich als vorteilhaft herausgestellt, um eine besonders kompakte Bauweise zu ermöglichen und eine beschädigungsfreie Auslenkung der Wandlerfolie in einer Folienebene von > 10%, vorzugsweise zwischen 15% und 40%, insbesondere bis zu 100% sicherzustellen. Weiter vorteilhaft ist diese Schichtdicke ausreichend groß, um einen besonders guten Stromdurchfluss durch die Elektrodenlagen bei Benutzung des dielektrischen Wandlers sicherzustellen.

In einer Ausgestaltung der Erfindung sind benachbarte Wandlerfolien in Randbereichen miteinander verbunden. Die Verbindung ist vorzugsweise vollflächig stoffschlüssig, insbesondere durch Verwendung eines Klebemittels.

Denkbar ist, dass eine Oberflächenaktivierung von Randbereichen benachbarter Wandlerfolien, beispielsweise durch Plasma, erfolgt, wobei bei Kontakt benachbarter Randbereiche eine vorzugsweise vollflächige stoffschlüssige Verbindung ausgebildet wird. Denkbar ist außerdem, dass benachbarte Wandlerfolien nach Oberflächenaktivierung vollflächig miteinander verbunden werden. Vorteilhaft ist kein Klebemittel erforderlich. Eine Steifigkeit eines derart verbundenen Wandlerfolienstapels ist vergleichbar mit derjenigen eines Wandlerfolienstapels, dessen benachbarte Wandlerfolien lediglich in Randbereichen miteinander verbunden sind. Vorteilhaft wird ein besonders lange haltbarer dielektrischer Wandler ausgebildet.

In einer Ausgestaltung der Erfindung ist eine Kontaktfläche des Kontaktelements mit einer der Elektrodenlagen in einer Ebene angeordnet, die parallel zu einer Längsrichtung des Wandlers ist. Dadurch, dass ein dielektrischer Wandler üblicherweise in einer Längsrichtung, also in Lagenrichtung, eine besonders große Auslenkung erfährt, wird vorteilhaft sichergestellt, dass keine Ablösung des Kontaktelements von der Elektrodenlage erfolgt.

In einer weiteren Ausgestaltung der Erfindung sind zwischen 2 und 100, insbesondere zwischen 2 und 50, vorzugsweise zwischen 2 und 20 Wandlerfolien vorgesehen. Vorteilhaft sind sowohl Wandler mit einer großen als auch einer kleinen Lagenanzahl herstellbar.

Gemäß der Erfindung ist auf einer Seite oder auf zwei gegenüberliegenden Seiten ein Mittel zur Versteifung sowie zur elektrischen Kontaktierung des Wandlers mit einem elektrischen oder elektronischen Bauteil vorhanden, wobei das Versteifungs- und Kontaktierungsmittel als Platine ausgebildet ist. Geschaffen wird ein Halbzeug zur Herstellung eines Aktors oder eines Sensors. Vorteilhaft ist eine Standardisierung für bestimmte Anwendungsfälle möglich. Herstellungskosten sinken.

In einer weiteren Ausgestaltung der Erfindung sind mindestens zwei der Wandlerfolien mit Durchgangsöffnungen unterschiedlicher Größe, Form und/oder Orientierung in einer Wandlerfolienenebene versehen. Vorteilhaft kann ein Querschnitt oder eine Querschnittsänderung in Dickenrichtung einer Ausnehmung oder eines Durchgangskanals maßgeschneidert werden. Beispielsweise können Durchgangsöffnungen benachbarter Wandlerfolien versetzt zueinander angeordnet werden, um einen besonders großen Kontaktbereich mit einer Elektrodenlage auszubilden. Dadurch kann eine im Wesentlichen schiefzylindrische Ausnehmung ausgebildet werden, die mehrere Zylindersegmente aufweist, die treppenartig angeordnet sind, wobei Stufen Kontaktbereiche bilden. Zweckmäßigerweise ist jede Elektrodenlage einstückig ausgebildet und/oder weist eine konstante Dicke auf.

In einer Ausgestaltung eines (nicht erfindungsgemäßen) Verfahrens werden die Wandlerfolien in einer Längsrichtung derart zueinander versetzt laminiert, dass benachbarte Durchgangsöffungen zueinander versetzt sind. Dadurch wird eine Herstellung im Additivverfahren möglich, bei dem auf identische Halbzeuge, das heißt je nach Anwendungsfall auf eine bestimmte Anzahl an Wandlerfolien, zurückgegriffen werden kann. Durch deren Laminierung wird eine besonders haltbare Verbindung benachbarter Wandlerfolien erreicht.

In einer weiteren Ausgestaltung des (nicht erfindungsgemäßen) Verfahrens sind Obeflächenbereiche vorgesehen, die nicht mit der elektrisch kontaktierbaren und leitfähigen Schicht belegt werden. Vorteilhaft wird eine Fehlkontaktierung verhindert.

Zweckmäßigerweise ist das (nicht erfindungsgemäße) Verfahren zur Herstellung eines dielektrischen Wandlers zur Verwendung in einem Membranaktor, einem Membransensor oder einem Membrangenerator vorgesehen.

Die Erfindung wird nachfolgend anhand von Ausführungsbeispielen und der beigefügten, sich auf die Ausführungsbeispiele beziehenden Zeichnungen, näher erläutert. Es zeigen:
- Fig. 1: eine erste Ausführungsform eines erfindungsgemäßen Wandlers mit einem Detail,
- Fig. 2: weitere Ausführungsformen eines erfindungsgemäßen Wandlers,
- Fig. 3: eine besondere Ausführungsform eines erfindungsgemäßen Wandlers.

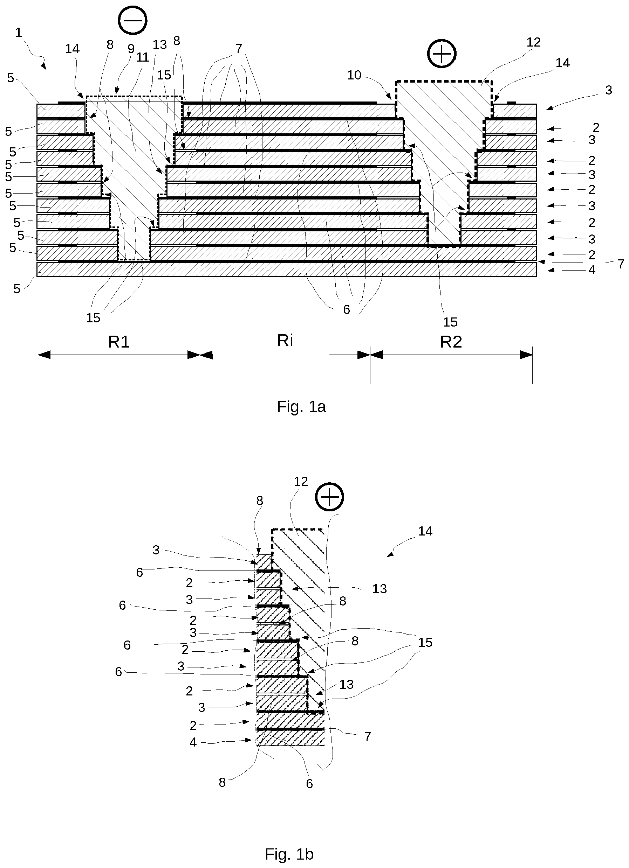

Ein in Fig. 1a in einer geschnittenen Seitenansicht schematisch gezeigter dielektrischer Wandler (1) weist zehn Lagen Wandlerfolien (2,3) sowie eine eine Decklage bildende Wandlerfolie (4) auf, wobei jede Wandlerfolie (2-4) eine aus Silikon gebildete Folie (5) sowie eine Elektrodenlage (6, 7) aufweist, die durch ein Beschichtungsverfahren auf die Folie (5) aufgebracht ist. Jede Elektrodenlage (6,7) ist aus einem nichtmetallischen Material gebildet, das in eine Kunststoffmatrix eingebettete Kohlenstoffpartikel aufweist.

In Randbereichen (R1, R2) sind benachbarte Wandlerfolien (2-4) vollflächig stoffschlüssig miteinander verbunden, vorzugsweise durch ein Klebemittel. In einem Innenbereich Ri liegen benachbarte Wandlerfolien (2-4) vollflächig aneinander an.

In Oberflächenbereichen (8) ist die Elektrodenlage (6, 7) unterbrochen, das heißt in diesen Bereichen weisen die Wandlerfolien (2-4) keine Elektrodenlage (6, 7) auf.

In den Wandler (1) sind abschnittsweise rotationssymmetrische Ausnehmungen (9, 10) mit rundem Querschnitt sowie einer treppenförmigen Verjüngung senkrecht zu den einzelnen Lagen Wandlerfolien (2-4) in Dickenrichtung eingebracht, die dazu vorgesehen sind, mit einem flexiblen, elektrisch leitfähigen Füllmaterial befüllt zu werden, um jeweils ein Kontaktelement (11, 12) auszubilden. An das Kontaktelement (11) kann der Minuspol (-) einer steuerbaren Spannungsquelle angelegt werden, an das Kontaktelement (12) der Pluspol (+).

Paarweise benachbarte Wandlerfolien (2, 3) bilden eine Stufe (13) aus, auf deren einer Öffnung (14) der Ausnehmung (9, 10) zugewandten Seite ein sich in Umfangsrichtung der Ausnehmung (9, 10) erstreckender Kontaktbereich (15) der Elektrodenlage (6, 7) ausgebildet ist, in dem die in den Ausnehmungen befindlichen Kontaktelemente (11, 12) mit der Elektrodenlage (6, 7) elektrisch und mechanisch, insbesondere kraft-, stoff- und/oder formschlüssig, verbunden sind. Die Elektrodenlage (6) ist mit dem Kontaktelement (12) verbunden, die Elektrodenlage (7) mit dem Kontaktelement (11). Dadurch wird sichergestellt, dass benachbarte Elektrodenlagen (6, 7) elektrisch mit gegensätzlichen Polen verbunden sind und eine bestimmungsgemäße Benutzung des Wandlers (1) beispielsweise in einem Aktor, einem Sensor oder einem Generator möglich ist. Eine Fehlkontaktierung wird insbesondere durch die elektrodenfreien Oberflächenbereiche (8) sichergestellt.

Details eines Wandlers (1) gemäß Fig. 1a sind in Fig. 1b in einer geschnittenen Seitenansicht gezeigt.

Ein in Fig. 1 gezeigter Wandler ist herstellbar, indem Folien (5) mit einer Elektrodenlage (6,7) beschichtet, mehrere Wandlerfolien (2-4) laminiert und die Ausnehmungen (9, 10) durch ein subtraktives Verfahren, beispielsweise durch Laserablation, eingebracht werden.

Denkbar ist, dass zur Herstellung mehrere mit einem Durchgang in Dickenrichtung versehene Wandlerfolien (2-4) derart laminiert werden, beispielsweise in Folienlängsrichtung versetzt zueinander, dass übereinander angeordnete Durchgänge mehrerer Wandlerfolien (2-4) eine Ausnehmung (9, 10) ausbilden.

Denkbar ist außerdem, dass zur Herstellung mehrere mit einem Durchgang in Dickenrichtung versehene Wandlerfolien (2-4) derart laminiert werden, dass benachbarte Durchgänge in Dickenrichtung übereinander angeordnet sind, wobei die Durchgänge voneinander verschiedene Durchmesser aufweisen.

Obwohl die Ausnehmungen (9, 10) eines in Fig. 1 gezeigten Wandlers (1) identisch sind, ist dies nicht unbedingt erforderlich. Voneinander verschiedene Ausnehmungen sind denkbar.

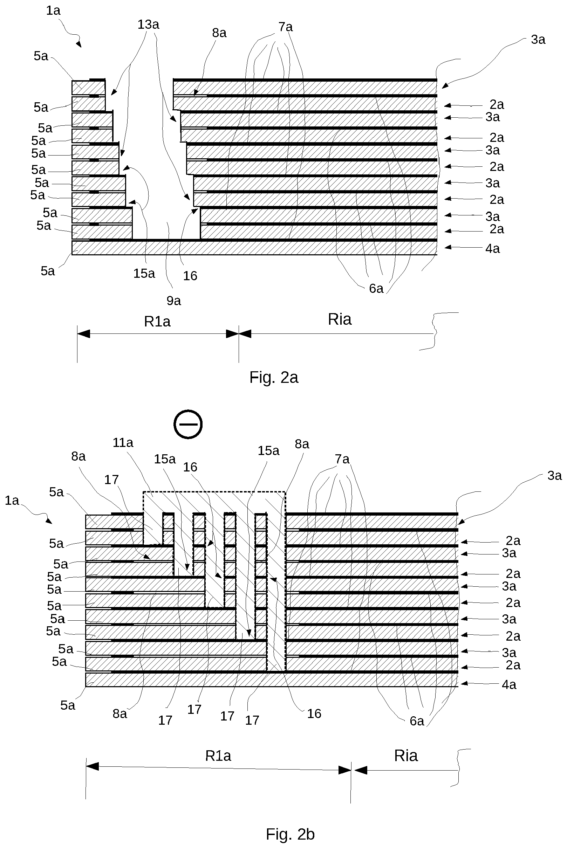

Es wird nun auf Fig. 2 Bezug genommen, wo gleiche oder gleichwirkende Teile mit derselben Bezugszahl wie in Fig. 1 bezeichnet sind und der betreffenden Bezugszahl jeweils der Buchstabe a beigefügt ist.

Ein in Fig. 2a in einer geschnittenen Seitenansicht schematisch, ausschnittsweise gezeigter dielektrischer Wandler (1a), in dem aus Gründen der Übersichtlichkeit keine Kontaktelemente gezeigt sind, unterscheidet sich von demjenigen in Fig. 1 gezeigten dadurch, dass eine Ausnehmung (9a) schiefzylindrisch mit runden Querschnitt und Stufen (13a) ausgebildet ist. In diesem Ausführungsbeispiel sind Kontaktbereiche (16) erkennbar, in denen ausschließlich ein Kontakt mit Stirnseiten der Elektrodenlagen (6a, 7a) möglich ist.

Ein in Fig. 2b in einer geschnittenen Seitenansicht schematisch, ausschnittsweise gezeigter dielektrischer Wandler (1a), unterscheidet sich von denjenigen in Fig. 1 und 2a gezeigten dadurch, dass ein gestrichelt dargestelltes Kontaktelement (11a) kammartig ausgebildet ist, wobei fünf Kammzähne (17) sich jeweils über mehrere Wandlerfolien (2a, 3a) erstrecken. Je länger ein Kammzahn (17) ist, desto mehr umlaufende stirnseitige Kontaktbereiche (16) werden ausgebildet.

Denkbar ist, dass anstelle eines Kontaktelements (11, 12; 11a, 12a) eine elektrisch leitende Schicht in eine Ausnehmung (9, 10; 9a, 10a) eingebracht wird, die mit Elektrodenlagen (6, 7; 6a, 7a) elektrisch leitend verbunden ist.

Ferner ist denkbar, dass ein Kontaktelement (11, 12; 11a, 12a) ein vorgefertigtes Bauteil ist, welches zur Kontaktierung mit Elektrodenlagen (6, 7; 6a, 7a) in Ausnehmungen (9, 10, 9a, 10a) eingesteckt wird und durch eine Klemmverbindung gehalten wird. Andere Verbindungsarten sind denkbar, insbesondere eine stoff-, form- und/oder kraftschlüssige Verbindung.

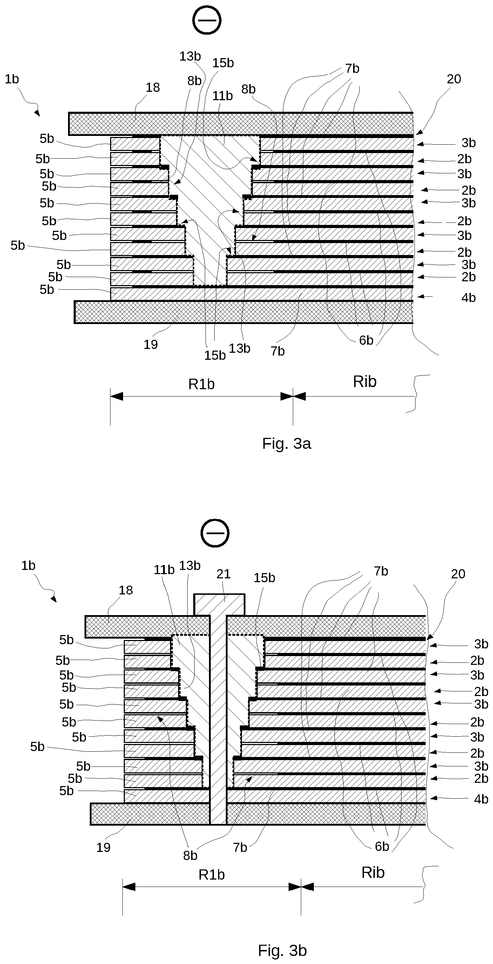

Es wird nun auf Fig. 3 Bezug genommen, wo gleiche oder gleichwirkende Teile mit derselben Bezugszahl wie in Fig. 1 und 2 bezeichnet sind und der betreffenden Bezugszahl jeweils der Buchstabe b beigefügt ist.

Bei einer in Fig. 3a gezeigten, besonderen Ausführungsform eines erfindungsgemäßen Wandlers sind eine Ansteuerplatine (18) sowie eine Trägerplatte (19) vorgesehen, zwischen denen mehrere Lagen Wandlerfolien (2b, 3b) angeordnet sind. Eine Verbindung mit der Ansteuerplatine (18), der Trägerplatte (19) und/oder einem Kontaktelement (11b, 12b) kann stoff-, kraft- und/oder formschlüssig sein. Eine obere Elektrodenlage (20) bildet dazu eine Kontaktlage zu der Ansteuerplatine (18) und ist in diesem Ausführungsbeispiel stoffschlüssig mit der Ansteuerplatine (18) verbunden.

Bei einer in Fig. 3b gezeigten, besonderen Ausführungsform eines erfindungsgemäßen Wandlers sind eine Ansteuerplatine (18) sowie eine Trägerplatte (19) vorgesehen, zwischen denen mehrere Lagen Wandlerfolien (2b, 3b) angeordnet sind. Der Stapel ist zwischen der Platine (18) sowie der Trägerplatte (19) eingeklemmt und durch eine Schraubverbindung gehalten, wobei eine Halteschraube (21) durch ein Kontaktelement (11b, 12b) hindurchgeführt ist.

Zur Herstellung eines in Fig. 3b gezeigten Wandlers (1b) können die Wandlerfolien (2b, 3b) mit einem Durchgangskanal versehen werden - vor oder nach deren Laminierung- der sich in Dickenrichtung erstreckt.

Denkbar ist, dass mehrere Lagen Wandlerfolien (2, 3; 2a, 3a; 2b, 3b) ausschließlich kraftschlüssig zwischen einer Ansteuerplatine (18) und einer Trägerplatte (19) eingespannt oder eingeklemmt sind.

Denkbar ist ferner, dass benachbarte Wandlerfolien (2, 3; 2a, 3a; 2b, 3b) in einem Innenbereich (Ri; Ria; Rib) stoffschlüssig miteinander verbunden sind.

Außerdem ist denkbar, dass eine Ansteuerplatine (18) ein Kontaktelement (11b) aufweist, welches beim Verbinden einer Platine (18) mit Wandlerfolien (2b-4b, 20) in eine Ausnehmung (11b) eintaucht und mit Elektrodenlagen (6b, 7b) elektrisch leitend kontaktiert wird.

Es versteht sich, dass sämtliche Kombinationen von Merkmalen der in Fig. 1 bis 3 gezeigten Ausführungsformen denkbar sind.

## Patentansprüche

1. Dielektrischer Wandler (1; 1a; 1b) zur Verwendung in einem Sensor, Aktor oder Generator, der mehrere Lagen Wandlerfolien (2, 3, 4; 2a, 3a, 4a; 2b, 3b, 4b, 20) umfasst, wobei auf wenigstens eine Seite einer jeden Wandlerfolie (2, 3, 4; 2a, 3a, 4a; 2b, 3b, 4b, 20) eine eine Elektrodenlage (6, 7; 6a, 7a; 6b, 7b, 20) bildende, elektrisch kontaktierbare und leitfähige Schicht aufgebracht ist, und mindestens zwei Kontaktelemente (11, 12; 11a; 11b) vorhanden sind, von denen jedes wenigstens teilweise in einer Ausnehmung (9, 10; 9a) oder in einem Durchgangskanal angeordnet ist und sich über mindestens eine Lage Wandlerfolien (2, 3, 4; 2a, 3a, 4a; 2b, 3b, 4b, 20) erstreckt, wobei benachbarte Elektrodenlagen (6, 7; 6a, 7a; 6b, 7b, 20) mit verschiedenen Kontaktelementen (11, 12; 11a; 11b) elektrisch leitend verbunden sind,
**dadurch gekennzeichnet,**
**dass** auf einer Seite ein Mittel (18) zur Versteifung sowie zur elektrischen Kontaktierung des Wandlers (1; 1a; 1b) mit einem elektrischen oder elektronischen Bauteil vorhanden ist, wobei das Versteifungs- und Kontaktierungsmittel als Platine (18) ausgebildet ist.

2. Dielektrischer Wandler nach Anspruch 1,
**dadurch gekennzeichnet,**
**dass** sich mindestens eines der Kontaktelemente (11, 12; 11a; 11b) in Dickenrichtung in den Wandler (1; 1a; 1b) hinein erstreckt, oder eine Beschichtung umfasst, die eine Innenseite der Ausnehmung (9, 10; 9a) oder des Durchgangskanals belegt.

3. Dielektrischer Wandler nach Anspruch 1 oder 2,
**dadurch gekennzeichnet,**
**dass** mindestens eines der Kontaktelemente (11, 12; 11a; 11b) treppen- oder kammartig ausgebildet ist.

4. Dielektrischer Wandler nach einem der Ansprüche 1 bis 3,
**dadurch gekennzeichnet,**
**dass** die Elektrodenlage (6, 7; 6a, 7a; 6b, 7b, 20) ein nichtmetallisches Material aufweist oder aus einem nichtmetallischen Material gebildet ist, insbesondere Kohlenstoff, vorzugsweise in eine Kunststoffmatrix eingebettete Kohlenstoffpartikel.

5. Dielektrischer Wandler nach einem der Ansprüche 1 bis 4,
**dadurch gekennzeichnet,**
**dass** jede Wandlerfolie (2, 3, 4; 2a, 3a, 4a; 2b, 3b, 4b, 20) mindestens einen Oberflächenbereich (8; 8a; 8b) umfasst, in dem die Elektrodenlage (6, 7; 6a, 7a; 6b, 7b, 20) unterbrochen ist.

6. Dielektrischer Wandler nach einem der Ansprüche 1 bis 5,
**dadurch gekennzeichnet,**
**dass** die Wandlerfolien (2, 3, 4; 2a, 3a, 4a; 2b, 3b, 4b, 20) eine Dicke zwischen 5 µm und 200 µm aufweisen, insbesondere zwischen 10 µm und 100 µm, besonders bevorzugt zwischen 20 µm und 50 µm, und/oder aus einem Polymermaterial gebildet sind, das Polysiloxan umfasst.

7. Dielektrischer Wandler nach einem der Ansprüche 1 bis 6,
**dadurch gekennzeichnet,**
**dass** die Dicke einer Elektrodenlage (6, 7; 6a, 7a; 6b, 7b, 20) zwischen 500 nm und 100 µm beträgt, vorzugsweise zwischen 1 µm und 50 µm, besonders bevorzugt zwischen 1 µm und 5 µm.

8. Dielektrischer Wandler nach einem der Ansprüche 1 bis 7,
**dadurch gekennzeichnet,**
**dass** benachbarte Wandlerfolien (2, 3, 4; 2a, 3a, 4a; 2b, 3b, 4b, 20) in Randbereichen (R1, R2; R1a; R1b) miteinander verbunden sind.

9. Dielektrischer Wandler nach einem der Ansprüche 1 bis 8,
**dadurch gekennzeichnet,**
**dass** zwischen 2 und 100, insbesondere zwischen 2 und 50, vorzugsweise zwischen 2 und 20 Wandlerfolien (2, 3, 4; 2a, 3a, 4a; 2b, 3b, 4b, 20) vorhanden sind.

10. Sensor, Aktor oder Generator, der einen dielektrischen Wandler (1; 1a; 1b) nach einem der Ansprüche 1 bis 9 aufweist.

## Claims

1. A dielectric transducer (1; 1a; 1b) for use in a sensor, actuator or generator comprising a plurality of layers of transducer foils (2, 3, 4; 2a, 3a, 4a; 2b, 3b, 4b, 20), wherein on at least one side of each transducer foil (2, 3, 4; 2a, 3a, 4a; 2b, 3b, 4b, 20) an electrically contactable and conductive layer forming an electrode layer (6, 7; 6a, 7a; 6b, 7b, 20) is applied, and at least two contact elements (11, 12; 11a; 11b) are present, each of which is at least partially located in a recess (9, 10; 9a) or in a through-channel and extending over at least one layer of transducer foils (2, 3, 4; 2a, 3a, 4a; 2b, 3b, 4b, 20), neighbouring electrode layers (6, 7; 6a, 7a; 6b, 7b, 20) being electrically conductively connected to different contact elements (11, 12; 11a; 11b) are electrically conductively connected, **characterised in that** a means (18) for stiffening and for electrically contacting the transducer (1; 1a; 1b) with an electrical or electronic component is provided on one side, the stiffening and contacting means being in the form of a circuit board (18).

2. Dielectric transducer according to claim 1, **characterised in that** at least one of the contact elements (11, 12; 11a; 11b) extends into the transducer (1; 1a; 1b) in the thickness direction, or comprises a coating which occupies an inner side of the recess (9, 10; 9a) or of the through-channel.

3. Dielectric transducer according to claim 1 or 2, **characterised in that** at least one of the contact elements (11, 12; 11a; 11b) is of a stepped or comb-like design.

4. Dielectric transducer according to one of claims 1 to 3, **characterised in that** the electrode layer (6, 7; 6a, 7a; 6b, 7b, 20) has a non-metallic material or is formed from a non-metallic material, in particular carbon, preferably carbon particles embedded in a plastic matrix.

5. Dielectric transducer according to one of claims 1 to 4, **characterised in that** each transducer foil (2, 3, 4; 2a, 3a, 4a; 2b, 3b, 4b, 20) comprises at least one surface region (8; 8a; 8b) in which the electrode layer (6, 7; 6a, 7a; 6b, 7b, 20) is interrupted.

6. Dielectric transducer according to one of claims 1 to 5, **characterised in that** the transducer foils (2, 3, 4; 2a, 3a, 4a; 2b, 3b, 4b, 20) have a thickness of between 5 µm and 200 µm, in particular between 10 µm and 100 µm, particularly preferably between 20 µm and 50 µm, and/or are formed from a polymer material comprising polysiloxane.

7. Dielectric transducer according to one of claims 1 to 6, **characterised in that** the thickness of an electrode layer (6, 7; 6a, 7a; 6b, 7b, 20) is between 500 nm and 100 µm, preferably between 1 µm and 50 µm, particularly preferably between 1 pm and 5 µm.

8. Dielectric transducer according to one of claims 1 to 7, **characterised in that** adjacent transducer foils (2, 3, 4; 2a, 3a, 4a; 2b, 3b, 4b, 20) are connected to one another in edge areas (R1, R2; R1a; R1b).

9. Dielectric transducer according to one of claims 1 to 8, **characterised in that** between 2 and 100, in particular between 2 and 50, preferably between 2 and 20 transducer foils (2, 3, 4; 2a, se, 4a; 2b, sb, 4b, 20) are present.

10. Sensor, actuator or generator comprising a dielectric transducer (1; 1a; 1b) according to one of claims 1 to 9.

## Revendications

1. Transducteur diélectrique (1 ; 1a ; 1b) destiné à être utilisé dans un capteur, un actionneur ou un générateur, comprenant plusieurs couches de feuilles de transducteur (2, 3, 4 ; 2a, 3a, 4a; 2b, 3b, 4b, 20), dans lequel au moins une face de chaque feuille de transducteur (2, 3, 4; 2a, 3a, 4a ; 2b, 3b, 4b, 20), une couche conductrice et pouvant être mise en contact électriquement, formant une couche d'électrodes (6, 7; 6a, 7a ; 6b, 7b, 20) est appliquée, et au moins deux éléments de contact (11, 12 ; 11a; 11b) sont présents, dont chacun est au moins partiellement logé dans un évidement (9, 10 ; 9a) ou dans un canal de passage et s'étend sur au moins une couche de feuilles de transducteur (2, 3, 4; 2a, 3a, 4a ; 2b, 3b, 4b, 20), des couches d'électrodes voisines (6, 7 ; 6a, 7a ; 6b, 7b, 20) étant reliées à différents éléments de contact (11, 12 ; 11a ; 11b) sont reliés de manière électriquement conductrice, **caractérisé en ce qu'**un moyen (18) de rigidification ainsi que de mise en contact électrique du convertisseur (1; 1a ; 1b) avec un composant électrique ou électronique est présent sur un côté, le moyen de rigidification et de mise en contact étant réalisé sous forme de platine (18).

2. Transducteur diélectrique selon la revendication 1, **caractérisé en ce qu'**au moins l'un des éléments de contact (11, 12 ; 11a ; 11b) s'étend dans le sens de l'épaisseur dans le transducteur (1 ; 1a ; 1b), ou comprend un revêtement qui occupe une face intérieure de l'évidement (9, 10 ; 9a) ou du canal de passage.

3. Transducteur diélectrique selon la revendication 1 ou 2, **caractérisé en ce qu'**au moins un des éléments de contact (11, 12 ; 11a ; 11b) est en forme d'escalier ou de peigne.

4. Transducteur diélectrique selon l'une des revendications 1 à 3, **caractérisé en ce que** la couche d'électrodes (6, 7 ; 6a, 7a ; 6b, 7b, 20) comporte un matériau non métallique ou est formée d'un matériau non métallique, notamment du carbone, de préférence des particules de carbone noyées dans une matrice plastique.

5. Transducteur diélectrique selon l'une des revendications 1 à 4, **caractérisé en ce que** chaque feuille de transducteur (2, 3, 4 ; 2a, 3a, 4a ; 2b, 3b, 4b, 20) comprend au moins une zone de surface (8 ; 8a ; 8b) dans laquelle la couche d'électrode (6, 7 ; 6a, 7a ; 6b, 7b, 20) est interrompue.

6. Transducteur diélectrique selon l'une quelconque des revendications 1 à 5, **caractérisé en ce que** les feuilles du transducteur (2, 3, 4 ; 2a, 3a, 4a ; 2b, 3b, 4b, 20) présentent une épaisseur comprise entre 5 µm et 200 µm, notamment entre 10 µm et 100 µm, plus préférentiellement entre 20 µm et 50 µm, et/ou sont formées d'un matériau polymère comprenant du polysiloxane.

7. Transducteur diélectrique selon l'une des revendications 1 à 6, **caractérisé en ce que** l'épaisseur d'une couche d'électrode (6, 7 ; 6a, 7a ; 6b, 7b, 20) est comprise entre 500 nm et 100 µm, de préférence entre 1 µm et 50 µm, plus préférentiellement entre 1 µm et 5 µm.

8. Transducteur diélectrique selon l'une des revendications 1 à 7, **caractérisé en ce que** des feuilles de transducteur voisines (2, 3, 4 ; 2a, 3a, 4a ; 2b, 3b, 4b, 20) sont reliées entre elles dans des zones de bord (R1, R2 ; R1a ; R1b).

9. Transducteur diélectrique selon l'une des revendications 1 à 8, **caractérisé en ce qu'**il y a entre 2 et 100, notamment entre 2 et 50, de préférence entre 2 et 20 feuilles de transducteur (2, 3, 4 ; 2a, se, 4a ; 2b, sb, 4b, 20).

10. Capteur, actionneur ou générateur comprenant un transducteur diélectrique (1 ; 1a ; 1b) selon l'une des revendications 1 à 9.
